(19) Europäisches Patentamt
European Patent Office
Office européen des brevets

(11) **EP 1 921 747 B1**

(12) **EUROPEAN PATENT SPECIFICATION**

(45) Date of publication and mention
of the grant of the patent:
**13.01.2010 Bulletin 2010/02**

(51) Int Cl.:
***H03F 3/45*** *(2006.01)*

(21) Application number: **06023152.9**

(22) Date of filing: **07.11.2006**

(54) **Amplifier arrangement and method for amplication**

Verstärkeranordnung und Verfahren zur Verstärkung

Dispositif amplificateur et procédé d'amplification

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**14.05.2008 Bulletin 2008/20**

(73) Proprietor: **austriamicrosystems AG**
**8141 Unterpremstätten (AT)**

(72) Inventor: **Singnurkar, Pramod**
**8020 Graz (AT)**

(74) Representative: **Epping - Hermann - Fischer**
**Patentanwaltsgesellschaft mbH**
**Ridlerstrasse 55**
**80339 München (DE)**

(56) References cited:
**DE-A1- 3 345 045       US-A1- 2004 113 696**
**US-B1- 6 747 514**

• **BINKLEY D M ET AL: "Micropower, 0.35-/spl mu/m partially depleted SOI CMOS preamplifiers having low white and flicker noise" 2003 IEEE INTERNATIONAL SOI CONFERENCE PROCEEDINGS. NEWPORT BEACH, CA, SEPT. 29 - OCT. 2, 2003, IEEE INTERNATIONAL SOI CONFERENCE, NEW YORK, NY : IEEE, US, 29 September 2003 (2003-09-29), pages 85-86, XP010666037 ISBN: 0-7803-7815-6**
• **FUKUMOTO T ET AL: "OPTIMIZING BIAS-CIRCUIT DESIGN OF CASCODE OPERATIONAL AMPLIFIER FOR WIDE DYNAMIC RANGE OPERATIONS" PROCEEDINGS OF THE 2001 INTERNATIONAL SYMPOSIUM ON LOW POWER ELECTRONICS AND DESIGN.ISLPED. HUNTINGTON BEACH, CA, AUG. 6 - 7, 2001, INTERNATIONAL SYMPOSIUM ON LOW POWER ELCTRONICS AND DESIGN, NEW YORK, NY : ACM, US, 6 August 2001 (2001-08-06), pages 305-309, XP001134627 ISBN: 1-58113-371-5**
• **YONG WANG ET AL: "A 3-V high-bandwidth integrator for magnetic disk read channel continuous-time filtering applications" CUSTOM INTEGRATED CIRCUITS CONFERENCE, 1998. PROCEEDINGS OF THE IEEE 1998 SANTA CLARA, CA, USA 11-14 MAY 1998, NEW YORK, NY, USA,IEEE, US, 11 May 1998 (1998-05-11), pages 427-430, XP010293893 ISBN: 0-7803-4292-5**

**Description**

The present invention relates to an amplifier arrangement, a use of the amplifier arrangement and a method for amplification.

Amplifier arrangements are common in industrial electronics and in consumer electronics such as mobile phones and digital cameras. Amplifier arrangements are also used in voltage converters which achieve an up- or a down-conversion of a supply voltage to generate an output voltage for electrical circuits. A current which flows through such a voltage converter is sensed by the use of amplifier arrangements.

Document "A 1-V Integrated Current-Mode Boost Converter in Standard 3.3/5-V CMOS Technologies", C. Leung et al., IEEE Journal of Solid-State Circuits, volume 40, no. 11, November 2005, pages 2265-2274, shows a boost converter using an amplifier in a current-sensing circuit.

Document "Accurate and Lossless Current-Sensing Techniques for Power Applications -- A Practical Myth?," G. A. Rincón-Mora, H. P. Forghanizadeh, Power Management Design Line, dated March 16, 2005 shows a current-sensing technique operating an amplifier.

Document US 2004/0113696 A1 is related to an amplifier circuit. An input voltage is provided to a first transistor. A current flows through the first transistor and through a further transistor. A current mirror comprises the further transistor and an additional transistor.

Document "Micropower, 0.35-$\mu$m Partially Depleted SOI CMOS Preamplifiers having Low White and Flicker Noise", D. M. Binkle et al., IEEE International SOI Conference Proceedings, September 29 to October 2, 2003, pages 85 to 86, refers to an differential input voltage preamplifier. An input voltage is provided to a first transistor. A current through the first transistor is mirrored by a further transistor and an additional transistor.

It is an object of the present invention to provide an amplifier arrangement, and a method for amplification operating at low voltages of an input signal.

This object is solved by an amplifier arrangement comprising the features of claim 1, and a method for amplification according to claim 14. Preferred embodiments are presented in the respective dependent claims.

An amplifier arrangement comprises a first transistor, a first bias transistor, a second transistor and a second bias transistor. The first transistor comprises a control terminal, a first and a second terminal. The first bias transistor also comprises a control terminal, a first and a second terminal. The first transistor and the first bias transistor are connected in series via a first node. The second transistor comprises a first terminal which is coupled to a second node. The second transistor further comprises a control terminal which is connected to a second terminal of the second transistor. The control terminal of the second transistor is also coupled to the control terminal of the first bias transistor via a third node. The second bias transistor also comprises a control terminal, a first and a second terminal. The second transistor and the second bias transistor are connected in series via the second node. The second node is coupled to the first node.

A first input signal is applied to the control terminal of the first transistor for amplification. The first bias transistor provides a current to the first transistor. The second bias transistor provides a current to the second transistor. A first voltage at the first node is coupled to a voltage at the second node by the coupling of the first node and the second node. A control voltage of the first bias transistor is clamped to a control voltage of the second transistor and to a voltage of the second terminal of the second transistor. A first amplified signal is provided which is equal to the control voltage of the first bias transistor.

It is an advantage of the coupling of the first bias transistor and the second transistor and of the coupling of the first and the second nodes that the first voltage at the first node can be very small. Since the first voltage is smaller than a voltage between the first terminal and the control terminal of the first transistor, the first input signal can have very small values. The first input signal can have the value of a reference potential or even lower values.

The second node is directly connected to the first node. The amplifier arrangement comprises a first connection line which couples the second node to the first node. In a preferred embodiment a current in the first connection line is approximately zero.

In a further development, the amplifier arrangement comprises a first current mirror which comprises the first bias transistor and a third bias transistor. A control terminal of the third bias transistor is connected to the control terminal of the first bias transistor. The first terminals of the first bias transistor and the third bias transistor are each connected to a reference potential terminal.

In a preferred embodiment, a first current which flows through the second transistor and a second current which flows through the second bias transistor are approximately equal. This can be achieved for example by the value 0 of the current in the first connection line.

In a further development, the amplifier arrangement comprises a fourth transistor, a fourth bias transistor, a fifth transistor and a fifth bias transistor. Each of the transistors comprises a control terminal, a first terminal and a second terminal. The fourth transistor is coupled to the fourth bias transistor via a fourth node. The fifth bias transistor and the fifth transistor are connected in series via a fifth node. The fifth node and the fourth node are coupled together. A control terminal of the fifth transistor is coupled to a second terminal of the fifth transistor and also to a control terminal of the fourth bias transistor via a sixth node. The first transistor and the fourth transistor are coupled together to each other.

A second input signal is applied to a control terminal of the fourth transistor. The fourth bias transistor provides a current to the fourth transistor. The fifth bias transistor provides a current to the fifth transistor. A voltage at the control terminal of the fourth bias transistor is clamped to a voltage at the second terminal of the fifth transistor and a control voltage at the control terminal of the fifth transistor. A second amplified signal is provided at the sixth node. By the coupling of the first and the fourth transistors a differential amplification of the first and the second input signals is achieved.

In an embodiment, the fourth node and the fifth node are directly connected together. In a preferred embodiment, the amplifier arrangement comprises a second connection line for connecting the fourth node to the fifth node. A current which flows in the second connection line is approximately zero.

In an embodiment, a third current which flows through the fifth transistor and a fourth current which flows through the fifth bias transistor are approximately equal to each other. This can be achieved for example by the value 0 of the current in the second connection line. In a preferred embodiment, the third current and the first current are also approximately equal.

In a development, the amplifier arrangement comprises a second current mirror which comprises the fourth bias transistor and the sixth bias transistor. The first terminals of the fourth bias transistor and of the sixth bias transistor are connected to the reference potential terminal. The control terminals of the fourth bias transistor and of the sixth bias transistor are connected to each other.

The amplifier arrangement comprises a third and a sixth transistor. A second terminal of the sixth transistor is connected to a second terminal of the sixth bias transistor. A second terminal of the third transistor is connected to a second terminal of the third bias transistor via a stage output terminal. A control terminal and a second terminal of the sixth transistor are connected together. The control terminals of the third and of the sixth transistors are also connected together. A stage output signal is provided at the stage output terminal. The stage output signal is provided depending on a current comparison of a current which flows through the first transistor with a current which flows through the fourth transistor.

In a development, the amplifier arrangement comprises a basis current mirror. The basis current mirror comprises a first mirror transistor to which a mirror current is applied. In an embodiment, the basis current mirror comprises a second and a sixth mirror transistor which are connected to the second and the fifth transistor. The first terminals of the mirror transistors of the basis current mirror are connected to the supply voltage and the control terminals of the mirror transistors of the basis current mirror are connected to the second terminal of the first mirror transistor.

In an embodiment, the basis current mirror comprises a fourth mirror transistor which couples a node between the first terminal of the first transistor and the first terminal of the fourth transistor to a supply voltage terminal. It is an advantage of the fourth mirror transistor to achieve a differential amplification of the first and the second input signals which are provided to the first transistor and to the fourth transistor.

According to an aspect of the invention, a method for amplification comprises the steps as defined in claim 14.

The control voltage of the first bias transistor is provided as a first amplified signal.

The first voltage at the first node and the voltage at the second node are equalized. The first transistor and the first bias transistor are connected in series via the first node. The second transistor and the second bias transistor are connected in series via the second node.

It is an advantage of the coupling of the control voltages of the second transistor and of the first bias transistor that a first input signal even with a small value can be amplified.

The following description of figures of exemplary embodiments will further illustrate and explain the invention. Devices with the same structure or the same effect, respectively, appear with equivalent reference numerals. A description of a part of a circuit or a device having the same function in different figures might not be repeated in each of the following figures.

Figure 1              shows a schematic diagram of an exemplary embodiment of an amplifier arrangement of the principle presented and

Figures 2A and 2B    show exemplary embodiments of current converters using an amplifier arrangement of the principle presented.

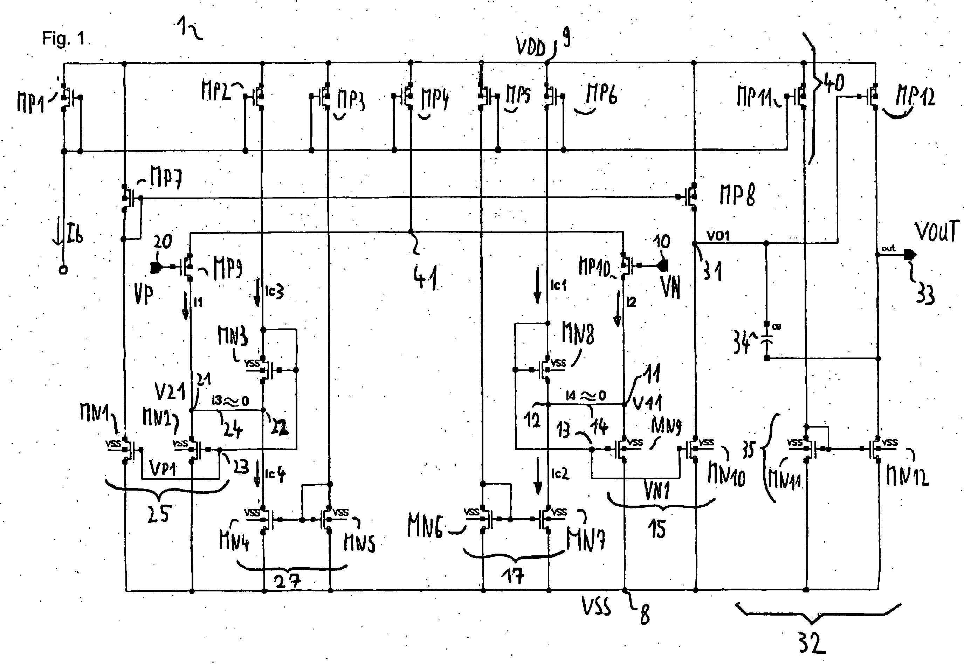

Figure 1 shows a schematic diagram of an exemplary embodiment of an amplifier arrangement of the principle presented. The amplifier arrangement 1 comprises a first transistor MP10, a first bias transistor MN9, a second transistor MN8, a second bias transistor MN7, a third transistor MP8, a third bias transistor MN10, an additional bias transistor MN6, a first mirror transistor MP1, a fourth mirror transistor MP4, a fifth mirror transistor MP5 and a sixth mirror transistor MP6. Each of the transistors comprises a control terminal, a first terminal and a second terminal. The first, the fourth, the fifth and the sixth mirror transistors MP1, MP4, MP5, MP6 are comprised by a basis current mirror 40. A first terminal of each of the four mirror transistors is connected to a supply voltage terminal 9. A control terminal of each of the four mirror transistors is connected to a second terminal of the first mirror transistor MP1. The control terminal of the first mirror transistor MP1 is connected to the second terminal of the first mirror transistor MP1.

The fourth mirror transistor MP4, the first transistor MP10 and the first bias transistor MN9 are connected in series together between the supply voltage terminal 9 and a reference potential terminal 8. The sixth mirror transistor MP6, the second transistor MN8 and the second bias transistor MN7 are also connected in series between the supply voltage terminal 9 and the reference potential terminal 8. The fifth mirror transistor MP5 and the additional bias transistor MN6 are also connected in series between the supply voltage terminal 9 and the reference potential terminal 8. The third transistor MP8 and the third bias transistor MN10 are connected in series between the supply voltage terminal 9 and the reference potential temperature 8.

A first node 11 is arranged between the first transistor MP10 and the first bias transistor MN9. A second node 12 is arranged between the second transistor MN8 and the second bias transistor MN7. The first node 11 and the second node 12 are directly connected to each other. The connection of the first node 11 to the second node 12 is achieved by a first connection line 14. The amplifier arrangement 1 comprises an input terminal 10 which is connected to a control terminal of the first transistor MP10. The node between the third transistor MP8 and the third bias transistor MN10 is a stage output terminal 31.

A second terminal of the second transistor MN8 is connected to a control terminal of the second transistor MN8. The control terminal of the second transistor MN8 is connected to a control terminal of the first bias transistor MN9 and also to a control terminal of the third bias transistor MN10 via a third node 13. Therefore, a first current mirror 15 comprises the first bias transistor MN9 and the third bias transistor MN10. A first terminal of the second bias transistor MN7 and a first terminal of the additional bias transistor MN6 are connected to the reference potential terminal 8. A control terminal of the second bias transistor MN7 is connected to a control terminal of the additional bias transistor MN6 and a second terminal of the additional bias transistor MN6. Therefore, a third current mirror 17 comprises the second bias transistor MN7 and the additional bias transistor MN6.

The amplifier arrangement 1 further comprises a fourth transistor MP9, a fourth bias transistor MN2, a fifth transistor MN3, a fifth bias transistor MN4, a sixth transistor MP7, a sixth bias transistor MN1, a further bias transistor MN5, a second mirror transistor MP2 and a third mirror transistor MP3. The basis current mirror 40 comprises the second and the third mirror transistors MP2, MP3. A node 41 is arranged between the fourth mirror transistor MP4 and the first transistor MP10. The fourth transistor MP9 and the fourth bias transistor MN2 are connected in series together and are arranged between the node 41 and the reference potential terminal 8. The second mirror transistor MP2, the fifth transistor MN3 and the fifth bias transistor MN4 are connected in series and are connected between the supply voltage terminal 9 and the reference potential terminal 8. The third mirror transistor MP3 and the further bias transistor MN5 are also connected in series between the supply voltage terminal 9 and the reference potential terminal 8. The amplifier arrangement 1 comprises a second input terminal 20 which is connected to a control terminal of the fourth transistor MP9. A fourth node 21 is arranged between the fourth transistor MP9 and the fourth bias transistor MN2. A fifth node 22 is arranged between the fifth transistor MN3 and the fifth bias transistor MN4. The fourth and the fifth node 21, 22 are directly connected to each other. The connection between the fourth and the fifth node 21, 22 is achieved by a second connection line 24. A second terminal of the fifth transistor MN3 is connected to a control terminal of the fifth transistor MN3. The control terminal of the fifth transistor MN3 is connected to a control terminal of the fourth bias transistor MN2 and a control terminal of the sixth bias transistor MN1 via a sixth node 23. Therefore, a second current mirror 25 comprises the fourth bias transistor MN2 and the sixth bias transistor MN1.

A control terminal of the fifth bias transistor MN4 is connected to a control terminal of the further bias transistor MN5 and also to a second terminal of the further bias transistor MN5. Therefore, a fourth current mirror 27 comprises the fifth bias transistor MN4 and the further bias transistor MN5. The sixth transistor MP7 and the sixth bias transistor MN1 are connected in series and are connected between the supply voltage terminal 9 and the reference potential terminal 8. A control terminal of the sixth transistor MP7 is connected to a second terminal of the sixth transistor MP7 and also to a control terminal of the third transistor MP8.

The amplifier arrangement 1 further comprises an output stage 32. The output stage 32 comprises a first output transistor MP12, a first output bias transistor MN12, a second output bias transistor MN11, a seventh mirror transistor MP11, a capacitor 34 and an output terminal 33. The output stage 32 couples the stage output terminal 31 to the output terminal 33. The stage output terminal 31 is connected to a control terminal of the first output transistor MP12. The first output transistor MP12 and the first output bias transistor MN12 are connected in series between the supply voltage terminal 9 and the reference potential terminal 8. The output terminal 33 of the amplifier arrangement 1 is arranged between the first output transistor MP12 and the first output bias transistor MN12. The seventh mirror transistor MP11 and the second output bias transistor MN11 are connected in series and are connected between the supply voltage terminal 9 and the reference potential terminal 8. A control terminal of the first output bias transistor MN12 is connected to a control terminal of the second output bias transistor MN11 and to a second terminal of the second output bias transistor MN11. A control terminal of the seventh mirror transistor MP11 is connected to a control terminal of the first mirror transistor MP1. The capacitor 34 couples the stage output terminal 31 to the output terminal 33.

A first input signal VN is applied to the first transistor MP10. The first bias transistor MN9 provides a current 12 to the first transistor MP10. The second bias transistor MN7 provides a current to the second transistor MN8. A first voltage V11 at the first node 11 is equal to a voltage at the second node 12 because of the direct coupling of the first and the second nodes 11, 12. A control voltage of the second transistor MN8 is equal to a control voltage of the first bias transistor MN9 and a control voltage of the third bias transistor MN10. The voltage of the second terminal of the second transistor MN8 is also equal to the control voltage of the second transistor MN8. A current I4 between the first and the second node 11, 12 is approximately zero. A first current Ic1 which flows through the second terminal of the sixth mirror transistor MP6 towards the second transistor MN8 is approximately equal to a second current Ic2 which flows through a controlled path of the second bias transistor MN7. A control voltage of the second bias transistor MN7 is provided by the third current mirror 17. The control voltage of the second bias transistor MN7 is supplied by the fifth mirror transistor MP5 and the additional bias transistor MN6 and is equal to the control voltage of the additional bias transistor MN6. As the second transistor MN8 is arranged between the basis current mirror 40 and the third current mirror 17, the first and the second currents Ic1, Ic2 are very stable. A first amplified signal VN1 is provided at the third node 13. As the first input voltage VN increases, the current I2 through the first transistor MP10 decreases, therefore the first voltage V11 at the first node 11 also decreases. This yields a decrease of the control voltages of the second transistor MN8 and of the first bias transistor MN9 and therefore of the first amplified signal VN1. A decrease of the first input voltage VN yields an increase of the first amplified signal VN1. As the first amplified signal VN1 is the control voltage of the third bias transistor MN10, the first amplified signal VN1 influences the stage output voltage V01.

The first bias transistor MN9 comprises a first width-to-length ratio of its channel. The second transistor MN8 comprises a second width-to-length ratio of its channel. Since the second ratio is larger than the first ratio, a voltage between the third node 13 and the second node 12 is less than a voltage between the third node 13 and the reference potential terminal 8. The first voltage V11 provided at the first node 11 is given by the following equations:

$$V11 = Vgs(MN9) - Vgs(MN8) \text{ and } V11 > VSS ,$$

wherein Vgs(MN9) is the gate source voltage of the second bias transistor MN9, Vgs(MN8) is the gate source voltage of the second transistor MN8 and VSS is a voltage at the reference potential terminal 8. The value of the first voltage V11 at the first node 11 provides a stable operation of the first bias transistor MN9 in the saturation region of the transistor. But the first bias transistor MN9 can also operate in the linear region of the transistor for low values of the first voltage V11. Since the first voltage V11 is much smaller than the source gate voltage of the first transistor MP10, the first input voltage VN can reach the value of a reference potential VSS which is provided at the reference potential terminal 8 or a lower value.

A second input voltage VP is provided to a control terminal of the fourth transistor MP9. A current I1 is provided to the fourth transistor MP9 by the fourth bias transistor MN2. A current is provided to the fifth transistor MN3 by the fifth bias transistor MN4. Because of the electric coupling of the fourth and the fifth nodes 21, 22 a second voltage V21 at the fourth node 21 is equal to a voltage at the fifth node 22. A current I3 flowing from the fourth to the fifth node 21, 22 is approximately zero. A control voltage of the fifth transistor MN3 is equal to a voltage of the second terminal of the fifth transistor MN3 and a control voltage of the fourth bias transistor MN2 and a control voltage of the sixth bias transistor MN1. A second amplified signal VP1 is provided at the sixth node 23. A third current Ic3 which flows through the second terminal of the second mirror transistor MP2 is approximately equal to a fourth current Ic4 which flows through a controlled path of the fifth bias transistor MN4. A control voltage of the fifth bias transistor MN4 is provided by the fourth current mirror 27. The control voltage of the fourth bias transistor MN4 is equal to a control voltage of the further bias transistor MN5 and also of a voltage at a second terminal of the further bias transistor MN5. Therefore, the control voltage of the fifth bias transistor MN4 is very stable because the control voltage is controlled by the basis current mirror 40 and by the fourth current mirror 27. The third current and the fourth current Ic3, Ic4 are also very stable because the fifth transistor MN3 is arranged between the basis current mirror 40 and the fourth current mirror 27. The second voltage V21 provided at the fourth node 21 is approximately given by the following equations:

$$V21 = Vgs(MN2) - Vgs(MN3) \text{ and } V21 > VSS ,$$

wherein Vgs(MN2) is the gate source voltage of the fourth bias transistor MN2, Vgs(MN3) is the gate source voltage of the fifth transistor MN3 and VSS is the voltage at the reference potential terminal 8. The fourth bias transistor MN2 comprises a third width-to-length ratio of its channel. The fifth transistor MN3 comprises a fourth width-to-length ratio of its channel. The fourth ratio is much larger than the third ratio. Therefore, a voltage between the sixth node 23 and the fifth node 22 is smaller than a voltage between the sixth node 23 and the reference potential terminal 8. In the absence of a differential signal across the first input terminal 10 and the second input terminal 20, the first and the second input voltages VN, VP are equal and the current I1 which flows through the fourth transistor MP9 is equal to the current I2 which flows through the first transistor MP10. The second voltage V21 provided at the fourth node 21 provides a stable operation of the fourth bias transistor MN2 in the saturation region of the transistor. But the fourth bias transistor MN2 can also operate in the linear region of the transistor for low values of the second voltage V21. Since the second voltage V21 is much smaller than the source-gate voltage of the fourth transistor MP9, the second input voltage VP can even have the value of the reference potential voltage VSS or a lower value.

The current I1 flowing through the fourth transistor MP9 and the fourth bias transistor MN2 is mirrored to the current flowing through the sixth bias transistor MN1 by the second current mirror 25 and then compared with the current flowing through the third bias transistor MN10. The stage output voltage V01 is a result of the comparison of the current which flows in the third bias transistor MN10 and the current which flows through the sixth bias transistor MN1 because the third transistor MP8 and the sixth transistor MP7 are arranged in the form of a current mirror. The output stage 32 provides an increase of the gain by amplifying the stage output signal V01 into the output signal VOUT.

The transistors of the amplifier arrangement are realized as field-effect transistors, abbreviated FETs, and comprise a gate terminal as the control terminal, a source terminal as the first terminal and a drain terminal as the second terminal. The transistors MN1, MN2, MN3, MN4, MN5, MN6, MN7, MN8, MN9, MN10, MN11, MN12 are n-channel FETs. The transistors MP1, MP2, MP3, MP4, MP5, MP6, MP7, MP8, MP9, MP10, MP11, MP12 are p-channel FETs. The FETs can be realized as metal-oxide-semiconductor FETs.

It is an advantage of the amplifier arrangement 1 that the first and the second voltages V21, V11 depend only on the gate source voltages of n-channel MOSFETS and, therefore, do not depend very much on process variations of a semiconductor fabrication process. It is an advantage of the amplifier arrangement 1 that it can be used at a low power supply voltage VDD. It is also an advantage of the amplifier arrangement 1 that the first and the second input voltages VN, VP can have high values, but can also have very low values, even below the reference potential VSS, thus resulting in a high dynamic range and a high common mode input-voltage range.

In an alternative embodiment, which is not shown, the amplifier arrangement 1 comprises a fifth current mirror instead of the third and the fourth current mirrors 17, 27. The fifth current mirror comprises the second and the fifth bias transistor MN4, MN7 and another bias transistor and controls both the second and the fifth bias transistor MN4, MN7.

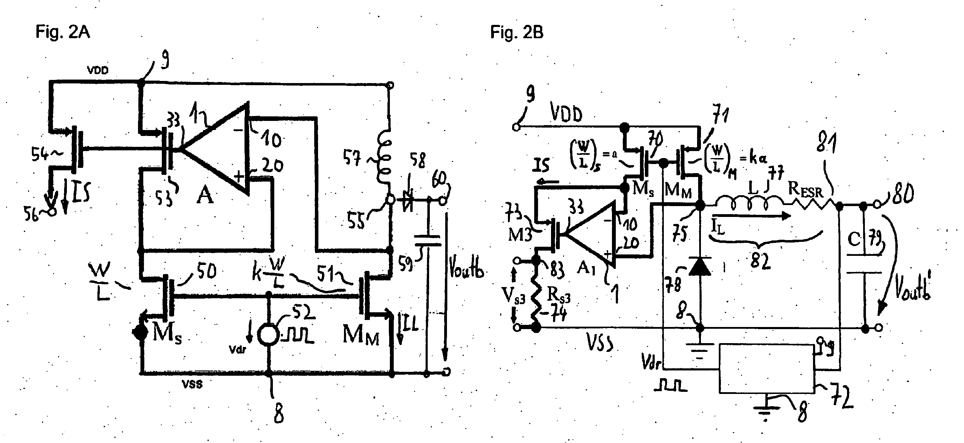

Figures 2A and 2B show exemplary embodiments of voltage converters in which an amplifier arrangement 1 which is shown in Figure 1 can be inserted.

Figure 2A shows an up-converter in the form of a boost converter which comprises the amplifier arrangement 1, a load transistor 51, a sense transistor 50, a first and a second transistor 53, 54, an inductor 57, a diode 58, a capacitor 59 and a voltage source 52. The inductor 57 comprises a coil. The inductor 57 and the load transistor 51 are connected in series between the supply voltage terminal 9 and the reference potential terminal 8. A node 55 which is arranged between the inductor 57 and the load transistor 51 is connected to an output terminal 60 of the boost converter via the diode 58. The output terminal 60 is coupled to the reference potential terminal 8 via the capacitor 59. The first transistor 53. and the sense transistor 50 are also arranged in a series circuit between the supply voltage terminal 9 and the reference potential terminal 8. A control terminal of the sense transistor 50 is connected to a control terminal of the load transistor 51 and also to the voltage source 52. The node 55 is connected to the first input terminal 10 of the amplifier arrangement 1. A node between the first transistor 53 and the sense transistor 50 is connected to the second input terminal 20 of the amplifier arrangement 1. The output terminal 33 of the amplifier arrangement 1 is connected to a control terminal of the first transistor 53 and a control terminal of the second transistor 54. The second transistor 54 couples the supply terminal 9 to an output terminal 56.

The voltage source 52 provides a drive voltage Vdr which controls the operation of the boost converter. If the voltage source 52 provides a drive voltage Vdr which switches the load transistor 51 and the sense transistor 52 in a conducting state, a current flows from the supply terminal 9 through the inductor 57 and the load transistor 51 to the reference potential terminal 8. Therefore, electrical energy is stored in the inductor 57 during a first phase. During a second phase the voltage source 52 provides a drive voltage Vdr which switches the load transistor 51 and the sense transistor 50 in a non-conducting state. Therefore, the current flowing through the inductor 57 cannot further flow through the blocked load transistor 51 and instead flows through the diode 58 to the capacitor 51 while increasing the output voltage Voutb of the boost converter. Since the first and the second input terminals 10, 20 of the amplifier arrangement 1 are connected to the second terminals of the load transistor 51 and of the sense transistor 50, a voltage at the output terminal 33 of the amplifier arrangement 1 is arranged in such a way that the drain to source voltage of the load transistor 51 is equal to the drain to source voltage of the sense transistor 50. If the width-to-length ratio of the load transistor 51 is by the factor k larger than the width-to-length ratio of the sense transistor 50, the current in the sense transistor 50 is, by a factor k, smaller than the current in the load transistor 51. The first and the second transistors 53, 54 are arranged in the form of a current mirror, therefore, a current IS is flowing through the node 56 which is equal to the current which flows through the sense transistor 50 and, therefore, by the factor k equal to the current which flows through the load transistor 51 during the first phase of operation.

It is an advantage of the boost converter, that the current flowing through the load transistor 51 can be measured without inserting a resistor in the current path which comprises the inductor 57 and the load transistor 51.

Figure 2B shows another exemplary embodiment of a converter in which the amplifier arrangement according Figure 1 can be inserted. A down-converter in the form of a buck converter is shown in Figure 2B. The voltage converter comprises a load transistor 71, a sense transistor 70, the amplifier arrangement 1, a first transistor 73, a first resistor 74, an inductor 82, a diode 78, a capacitor 79 and a controlling unit 72. The inductor 82 comprises an inductance 77 and a second resistor 81. A series circuit comprising the load transistor 71 and the inductor 82 connects the supply voltage terminal 9 to an output terminal 80 of the voltage converter. A node 75 which is arranged between the load transistor 71 and the inductor 82 is coupled to the reference potential terminal 8 via a diode 78. The diode 78 is oriented in such a way, that a current can flow from the reference potential terminal 8 to the node 75. The capacitor 79 couples the output terminal 80 of the current converter to the reference potential terminal 8. The sense transistor 70, the first transistor 73 and the first resistor 74 are connected in series between the supply voltage terminal 9 and the reference potential terminal 8. A node between the sense transistor 70 and the first transistor 73 is connected to the first input terminal 10 of the amplifier arrangement 1. The node 75 is connected to the second input terminal 20 of the amplifier arrangement 1. The output terminal 33 of the amplifier arrangement 1 is connected to a control terminal of the first transistor 73. The controller 72 is connected to a control terminal of the load transistor 71 and to a control terminal of the sense transistor 70. The controlling unit 72 is further connected to the output terminal 80 of the voltage converter, the supply voltage terminal 9 and the reference potential terminal 8.

In a first phase of operation, the controlling unit 72 provides a drive voltage Vdr to the control terminals of the load transistor 71 and the sense transistor 70 in such a way, that the load transistor 71 and the sense transistor 70 are switched in a conducting state. Therefore, a load current IL can flow from the supply terminal 9 through the load transistor 71 and the inductor 82 to the output terminal 80 and to the capacitor 79. In the first phase of operation, an output voltage Voutb' which is provided at the output terminal 80 of the voltage converter increases. The load transistor 71 comprises a width to length ratio of its channel, while the sense transistor comprises another width to length ratio of its channel. The load transistor 71 and the sense transistor 70 are arranged in a current mirror configuration. The first terminals of the load transistor 71 and the sense transistor 70 are connected to the supply voltage terminal 9, while the second terminals of these two transistors are connected to the two input terminals 10, 20 of the amplifier arrangement. Therefore, the drain to source voltage of the load transistor 71 is approximately equal to the drain to source voltage of the sense transistor 70. The amplifier arrangement 1 supplies a control voltage to the control terminal of the first transistor 73, so that a current IS flows through the sense transistor 70, the first transistor 73 and the first resistor 74. This sense current IS has a value by which the drain to source voltages of the load transistor 71 and the sense transistor 70 are matching. At a node 83 which is arranged between the first transistor 73 and the first resistor 74 a voltage VS3 is provided which is proportional to the sense current IS. Since the width to length ratios of the load transistor 71 and of the sense transistor 70 are different by a factor k, the sense current IS is by the factor k smaller than the load current IL during the first phase of the operation. Therefore, the sense current IS or the voltage VS3 can be used for the measurement of the load current IL.

In a second phase of operation, the controlling unit 72 switches the load transistor 71 and the sense transistor 70 in an open state. The load current IL which flows through the inductor 82 continues to flow through the diode 78. The energy, which was stored in the inductor 82 during the first phase, will be used to drive the load current IL during the second phase.

The accuracy of the sensing of the load current IL depends on the input-offset voltage of the amplifier arrangement 1. It is an advantage of the amplifier arrangement 1 shown in Figure 1, that the input-offset voltage is very small and, therefore, an accurate sensing of the load current IL can be achieved by the circuit shown in Figure 2B.

The voltage VS3 during the first phase can be calculated according to the following equation:

$$Vs3 = Rs3 \cdot IS = \frac{Rs3 \cdot IL}{k} \quad ,$$

wherein RS3 is the value of the first resistor 71, IL is the value of the load current IL and k is the factor between the width to length ratio of the load transistor 71 and the width to length ratio of the sense transistor 70.

Reference numerals

| | |
|---|---|
| 1 | amplifier arrangement |
| 8 | reference potential terminal |
| 9 | power supply terminal |
| 10 | first input terminal |
| 11 | first node |
| 12 | second node |
| 13 | third node |
| 14 | first connection line |
| 15 | first current mirror |
| 17 | third current mirror |
| 20 | second input terminal |
| 21 | fourth node |
| 22 | fifth node |
| 23 | sixth node |
| 24 | second connection line |
| 25 | second current mirror |
| 27 | fourth current mirror |
| 31 | stage output terminal |
| 32 | output stage |
| 33 | output terminal |
| 34 | capacitor |
| 40 | basis current mirror |
| 41 | node |
| 50 | sense transistor |
| 51 | load transistor |
| 52 | voltage source |
| 53 | first transistor |
| 54 | second transistor |
| 55, 56 | node |
| 57 | inductor |
| 58 | diode |
| 59 | capacitor |
| 60 | output terminal |
| 70 | sense transistor |
| 71 | load transistor |
| 72 | controlling unit |
| 73 | first transistor |
| 75 | node |
| 77 | inductivity |
| 78 | diode |
| 79 | capacitor |
| 80 | output terminal |
| 81 | second resistor |
| 82 | inductor |
| 83 | node |
| Ib | mirror current |
| Ic1 | first current |
| Ic2 | second current |
| Ic3 | third current |
| Ic4 | fourth current |
| IS | sense current |
| I1, I2, I3, I4 | current |
| k | factor |
| MN1 | sixth bias transistor |
| MN2 | fourth bias transistor |
| MN3 | fifth transistor |
| MN4 | fifth bias transistor |
| MN5 | further bias transistor |

| MN6 | additional bias transistor |
|---|---|
| MN7 | second bias transistor |
| MN8 | second transistor |
| MN9 | first bias transistor |
| MN10 | third bias transistor |
| MN11 | second output bias transistor |
| MN12 | first output bias transistor |
| MP1 | first mirror transistor |
| MP2 | second mirror transistor |
| MP3 | third mirror transistor |
| MP4 | fourth mirror transistor |
| MP5 | fifth mirror transistor |
| MP6 | sixth mirror transistor |
| MP7 | sixth transistor |
| MP8 | third transistor |
| MP9 | fourth transistor |
| MP10 | first transistor |
| MP11 | seventh mirror transistor |
| MP12 | first output transistor |
| VDD | supply voltage |
| Vdr | drive voltage |
| VOUT | output voltage |
| Voutb, Voutb' | output voltage |
| VP | second input voltage |
| VP1 | second amplified signal |
| VN | first input voltage |
| VN1 | first amplified signal |
| VSS | reference potential |
| V01 | stage output signal |
| V11 | first voltage |
| V21 | second voltage |

## Claims

1. Amplifier arrangement, comprising

   - a first transistor (MP10) with a control terminal to which a first input signal (VN) is supplied for amplification,
   - a first bias transistor (MN9) which is connected in series to the first transistor (MP10) via a first node (11),
   - a second transistor (MN8) with a first terminal, which is coupled to a second node (12), a second terminal and a control terminal;
   the control terminal of the second transistor (MN8) being coupled to the second terminal of the second transistor (MN8) and to a control terminal of the first bias transistor (MN9) via a third node (13) at which a first amplified signal (VN1) is provided, and
   - a second bias transistor (MN7), wherein the second transistor (MN8) and the second bias transistor (MN7) are connected in series via the second node (12),

   **characterized in that**
   the second node (12) is directly connected to the first node (11) via a first connection line (14) for coupling the second node (12) to the first node (11) so that a first voltage (V11) at the first node (11) and a voltage at the second node (12) are equalized.

2. Amplifier arrangement according to claim 1,
   wherein the amplifier arrangement (1) is designed such that a current (14) which flows in the first connection line (14) is approximately 0.

3. Amplifier arrangement according to claim 1 or 2, comprising a first current mirror (15) which comprises

- the first bias transistor (MN9) with a first terminal which is connected to a reference potential terminal (8) and
- a third bias transistor (MN10) with a first terminal which is connected to the reference potential terminal (8) and a control terminal which is coupled to the control terminal of the first bias transistor (MN9).

4. Amplifier arrangement according to one of claims 1 to 3, wherein the amplifier arrangement (1) is designed such that a first current (Ic1) which flows through the second transistor (MN8) is approximately equal to a second current (Ic2) which flows through the second bias transistor (MN7).

5. Amplifier arrangement according to one of claims 1 to 4, comprising

- a fourth transistor (MP9) with a control terminal to which a second input signal (VP) is supplied for amplification,
- a fourth bias transistor (MN2) which is coupled to the fourth transistor (MP9) via a fourth node (21),
- a fifth transistor (MN3) with a first terminal, which is coupled to a fifth node (22), a second terminal and a control terminal;
the control terminal of the fifth transistor (MN3) being coupled to the second terminal of the fifth transistor (MN3) and to a control terminal of the fourth bias transistor (MN2) via a sixth node (23) at which a second amplified signal (VP1) is provided, and
- a fifth bias transistor (MN4) which is coupled to the fifth transistor (MN3) via the fifth node (22),

wherein the fifth node (22) is coupled to the fourth node (21) and the first and the fourth transistors (MP9, MP10) are coupled to each other to provide a differential amplification of the first and the second input signals (VN, VP).

6. Amplifier arrangement according to claim 5,
wherein the fifth node (22) is directly connected to the fourth node (21) via a second connection line (24) for coupling the fifth node (22) to the fourth node (21) and wherein the amplifier arrangement (1) is designed such that a current I3 which flows in the second connection line (24) is approximately 0.

7. Amplifier arrangement according to claim 5 or 6, if dependent on claim 4,
wherein the amplifier arrangement (1) is designed such that a third current (Ic3) which flows through the fifth transistor (MN3) and a fourth current (Ic4) which flows through the fifth bias transistor (MN4) are approximately equal to the first current (Ic1).

8. Amplifier arrangement according to one of claims 5 to 7, comprising a second current mirror (25) which comprises

- the fourth bias transistor (MN2) with a first terminal which is connected to a reference potential terminal (8) and
- a sixth bias transistor (MN1) with a first terminal which is connected to the reference potential terminal (8) and a control terminal which is coupled to the control terminal of the fourth bias transistor (MN2).

9. Amplifier arrangement according to one of claims 5 to 8, comprising

- a third current mirror (17) for controlling the second bias transistor (MN7) and a fourth current mirror (27) for controlling the fifth bias transistor (MN4) or
- a fifth current mirror for controlling the second bias transistor (MN7) and the fifth bias transistor (MN4).

10. Amplifier arrangement according to one of claims 5 to 9, if dependent on claim 3,
comprising

- a sixth transistor (MP7) with a first terminal, a second terminal which is coupled to a second terminal of the sixth bias transistor (MN1), and a control terminal which is coupled to the second terminal of the sixth transistor (MP7),
- a third transistor (MP8) with a first terminal, a second terminal which is coupled to a second terminal of the third bias transistor (MN10) via a stage output terminal (31) and a control terminal;
the control terminal of the third transistor (MP8) being coupled to the control terminal of the sixth transistor (MP7) and
- the stage output terminal (31) at which a stage output signal (V01) is provided.

11. Amplifier arrangement according to claim 10,
comprising an output amplifier stage (32) which couples the stage output terminal (31) to an output terminal (33) of the amplifier arrangement (1) and comprises

- a first output transistor (MP12) which is connected between a supply voltage terminal (9) and the output terminal (33) and comprises a control terminal which is coupled to the stage output terminal (31),
- a first output bias transistor (MN12) which is connected between a reference voltage terminal (8) and the output terminal (33),
- a capacitor (34) which is connected between the stage output terminal (31) and the output terminal (33) and
- a sixth current mirror (35) comprising the first output bias transistor (MN12) and a second output bias transistor (MN11).

12. Amplifier arrangement according to one of claims 5 to 11, comprising a basis current mirror (40) which comprises

- a first mirror transistor (MP1) with a second terminal to which a mirror current (Ib) is applied and with a control terminal which is coupled to the second terminal of the first mirror transistor (MP1),
- a second mirror transistor (MP2) with a second terminal which is connected to the second terminal of the fifth transistor (MN3),
- a fourth mirror transistor (MP4) with a second terminal which is connected to the first terminal of the first transistor (MP10) via a node (41), and
- a sixth mirror transistor (MP6) with a second terminal which is connected to the second terminal of the second transistor (MN8),

wherein the first terminals of the first, the second, the fourth and the sixth mirror transistors (MP1, MP2, MP4, MP6) are connected to a supply voltage terminal (9) and the control terminals of the second, the fourth and the sixth mirror transistors (MP2, MP4, MP6) are connected to the second terminal of the first mirror transistor (MP1).

13. Amplifier arrangement according to one of claims 5 to 12, wherein

- a first voltage (V11) at the first node (11) is determined by a difference of

   - a voltage between the control terminal and the first terminal of the first bias transistor (MN9) and
   - a voltage between the control terminal and the first terminal of the second transistor (MN8); and

- a second voltage (V21) at the fourth node (21) is determined by a difference of

   - a voltage between the control terminal and the first terminal of the fourth bias transistor (MN2) and
   - a voltage between the control terminal and the first terminal of the fifth transistor (MN3).

14. Method for amplification,
comprising the steps of:

- providing a first input signal (VN) to a first transistor (MP10),
- providing a current (12) to the first transistor (MP10) using a first bias transistor (MN9) by connecting in series the first transistor (MP10) and the first bias transistor (MN9) via a first node (11),
- providing a current to a second transistor (MN8) using a second bias transistor (MN7) by connecting in series the second transistor (MN8) and the second bias transistor (MN7) via a second node (12),
- equalizing a control voltage of the first bias transistor (MN9) and a control voltage of the second transistor (MN8) and a voltage of a second terminal of the second transistor (MN8) and
- providing a first amplified signal (VN1) dependent on the control voltage of the first bias transistor (MN9),

**characterized in that**
a first voltage (V11) at the first node (11) and a voltage at the second node (12) are equalized by directly connecting the second node (12) to the first node (11) via a first connection line (14) for coupling the second node (12) to the first node (11).

**Patentansprüche**

1. Verstärkeranordnung, umfassend:

- einen ersten Transistor (MP10) mit einem Steueranschluss, in den ein erstes Eingangssignal (VN) zur Verstärkung eingespeist wird,
- einen ersten Vorspannungstransistor (MN9), der über einen ersten Knoten (11) mit dem ersten Transistor (MP10) in Reihe geschaltet ist,
- einen zweiten Transistor (MN8) mit einem ersten Anschluss, der mit einem zweiten Knoten (12) gekoppelt ist, einem zweiten Anschluss und einem Steueranschluss;
wobei der Steueranschluss des zweiten Transistors (MN8) mit dem zweiten Anschluss des zweiten Transistors (MN8) und über einen dritten Knoten (13), an dem ein erstes verstärktes Signal (VN1) bereitgestellt wird, mit einem Steueranschluss des ersten Vorspannungstransistors (MN9) gekoppelt ist, und
- einen zweiten Vorspannungstransistor (MN7), wobei der zweite Transistor (MN8) und der zweite Vorspannungstransistor (MN7) über den zweiten Knoten (12) in Reihe geschaltet sind,

**dadurch gekennzeichnet, dass**
der zweite Knoten (12) über eine erste Verbindungsleitung (14) direkt an den ersten Knoten (11) angeschlossen ist, um den zweiten Knoten (12) mit dem ersten Knoten (11) so zu koppeln, dass eine erste Spannung (V11) an dem ersten Knoten (11) und eine Spannung an dem zweiten Knoten (12) ausgeglichen sind.

2. Verstärkeranordnung nach Anspruch 1,
wobei die Verstärkeranordnung (1) so ausgelegt ist, dass ein Strom (I4), der in der ersten Verbindungsleitung (14) fließt, ungefähr 0 beträgt.

3. Verstärkeranordnung nach Anspruch 1 oder 2, eine erste Stromspiegelschaltung (15) umfassend, die umfasst:

- den ersten Vorspannungstransistor (MN9) mit einem ersten Anschluss, der an einen Referenzpotentialanschluss (8) angeschlossen ist, und
- einen dritten Vorspannungstransistor (MN10) mit einem ersten Anschluss, der an den Referenzpotentialanschluss (8) angeschlossen ist, und einem Steueranschluss, der mit dem Steueranschluss des ersten Vorspannungstransistors (MN9) gekoppelt ist.

4. Verstärkeranordnung nach einem der Ansprüche 1 bis 3, wobei die Verstärkeranordnung (1) so ausgelegt ist, dass ein erster Strom (Ic1), der durch den zweiten Transistor (MN8) fließt, ungefähr gleich einem zweiten Strom (Ic2) ist, der durch den zweiten Vorspannungstransistor (MN7) fließt.

5. Verstärkeranordnung nach einem der Ansprüche 1 bis 4, umfassend:

- einen vierten Transistor (MP9) mit einem Steueranschluss, in den ein zweites Eingangssignal (VP) zur Verstärkung eingespeist wird,
- einen vierten Vorspannungstransistor (MN2), der über einen vierten Knoten (21) mit dem vierten Transistor (MP9) gekoppelt ist,
- einen fünften Transistor (MN3) mit einem ersten Anschluss, der mit einem fünften Knoten (22) gekoppelt ist, einem zweiten Anschluss und einem Steueranschluss;
wobei der Steueranschluss des fünften Transistors (MN3) mit dem zweiten Anschluss des fünften Transistors (MN3) und über einen sechsten Knoten (23), an dem ein zweites verstärktes Signal (VP1) bereitgestellt wird, mit einem Steueranschluss des vierten Vorspannungstransistors (MN2) gekoppelt ist, und
- einen fünften Vorspannungstransistor (MN4), der über den fünften Knoten (22) mit dem fünften Transistor (MN3) gekoppelt ist,

wobei der fünfte Knoten (22) mit dem vierten Knoten (21) gekoppelt ist, und der erste und der vierte Transistor (MP9, MP10) miteinander gekoppelt sind, um eine Differenzverstärkung des ersten und des zweiten Eingangssignals (VN, VP) bereitzustellen.

6. Verstärkeranordnung nach Anspruch 5,
wobei der fünfte Knoten (22) über eine zweite Verbindungsleitung (24), um den fünften Knoten (22) mit dem vierten Knoten (21) zu koppeln, direkt an den vierten Knoten (21) angeschlossen ist, und wobei die Verstärkeranordnung (1) so ausgelegt ist, dass ein Strom (13), der in der zweiten Verbindungsleitung (24) fließt, ungefähr 0 beträgt.

7. Verstärkeranordnung nach Anspruch 5 oder 6, falls von Anspruch 4 abhängig,
wobei die Verstärkeranordnung (1) so ausgelegt ist, dass ein dritter Strom (Ic3), der durch den fünften Transistor (MN3) fließt, und ein vierter Strom (Ic4), der durch den fünften Vorspannungstransistor (MN4) fließt, ungefähr gleich dem ersten Strom (Ic1) sind.

8. Verstärkeranordnung nach einem der Ansprüche 5 bis 7, eine zweite Stromspiegelschaltung (25) umfassend, die umfasst:

   - den vierten Vorspannungstransistor (MN2) mit einem ersten Anschluss, der an einen Referenzpotentialanschluss (8) angeschlossen ist, und
   - einen sechsten Vorspannungstransistor (MN1) mit einem ersten Anschluss, der an den Referenzpotentialanschluss (8) angeschlossen ist, und einem Steueranschluss, der mit dem Steueranschluss des vierten Vorspannungstransistors (MN2) gekoppelt ist.

9. Verstärkeranordnung nach einem der Ansprüche 5 bis 8, umfassend:

   - eine dritte Stromspiegelschaltung (17) zum Steuern des zweiten Vorspannungstransistors (MN7) und eine vierte Stromspiegelschaltung (27) zum Steuern des fünften Vorspannungstransistors (MN4), oder
   - eine fünfte Stromspiegelschaltung zum Steuern des zweiten Vorspannungstransistors (MN7) und des fünften Vorspannungstransistors (MN4).

10. Verstärkeranordnung nach einem der Ansprüche 5 bis 9, falls von Anspruch 3 abhängig, umfassend:

   - einen sechsten Transistor (MP7) mit einem ersten Anschluss, einem zweiten Anschluss, der mit einem zweiten Anschluss des sechsten Vorspannungstransistors (MN1) gekoppelt ist, und einem Steueranschluss, der mit dem zweiten Anschluss des sechsten Transistors (MP7) gekoppelt ist,
   - einen dritten Transistor (MP8) mit einem ersten Anschluss, einem zweiten Anschluss, der über einen Stufenausgangsanschluss (31) mit einem zweiten Anschluss des dritten Vorspannungstransistors (MN10) gekoppelt ist, und einem Steueranschluss;
   wobei der Steueranschluss des dritten Transistors (MP8) mit dem Steueranschluss des sechsten Transistors (MP7) gekoppelt ist, und
   - den Stufenausgangsanschluss (31), an dem ein Stufenausgangssignal (V01) bereitgestellt wird.

11. Verstärkeranordnung nach Anspruch 10, eine Ausgangsverstärkerstufe (32) umfassend, die den Stufenausgangsanschluss (31) mit einem Ausgangsanschluss (33) der Verstärkeranordnung (1) koppelt und umfasst:

   - einen ersten Ausgangstransistor (MP12), der zwischen einem Netzspannungsanschluss (9) und dem Ausgangsanschluss (33) angeschlossen ist und einen Steueranschluss umfasst, der mit dem Stufenausgangsanschluss (31) gekoppelt ist,
   - einen ersten Ausgangsvorspannungstransistor (MN12), der zwischen einem Referenzspannungsanschluss (8) und dem Ausgangsanschluss (33) angeschlossen ist,
   - einen Kondensator (34), der zwischen dem Stufenausgangsanschluss (31) und dem Ausgangsanschluss (33) angeschlossen ist, und
   - eine sechste Stromspiegelschaltung (35), die den ersten Ausgangsvorspannungstransistor (MN12) und einen zweiten Ausgangsvorspannungstransistor (MN11) umfasst.

12. Verstärkeranordnung nach einem der Ansprüche 5 bis 11, eine Basisstromspiegelschaltung (40) umfassend, die umfasst:

   - einen ersten Spiegeltransistor (MP1) mit einem zweiten Anschluss, an den ein Spiegelstrom (Ib) angelegt wird, und mit einem Steueranschluss, der mit dem zweiten Anschluss des ersten Spiegeltransistors (MP1) gekoppelt ist,
   - einen zweiten Spiegeltransistor (MP2) mit einem zweiten Anschluss, der an den zweiten Anschluss des fünften Transistors (MN3) angeschlossen ist,
   - einen vierten Spiegeltransistor (MP4) mit einem zweiten Anschluss, der über einen Knoten (41) an den ersten Anschluss des ersten Transistors (MP10) angeschlossen ist, und
   - einen sechsten Spiegeltransistor (MP6) mit einem zweiten Anschluss, der an den zweiten Anschluss des zweiten Transistors (MN8) angeschlossen ist,

wobei die ersten Anschlüsse des ersten, des zweiten, des vierten und des sechsten Spiegeltranistors (MP1, MP2, MP4, MP6) an einen Netzspannungsanschluss (9) angeschlossen sind, und die Steueranschlüsse des zweiten, des vierten und des sechsten Spiegeltransistors (MP2, MP4, MP6) an den zweiten Anschluss des ersten Spiegeltransistors (MP1) angeschlossen sind.

13. Verstärkeranordnung nach einem der Ansprüche 5 bis 12, wobei

- eine erste Spannung (V11) am ersten Knoten (11) bestimmt ist durch eine Differenz

- einer Spannung zwischen dem Steueranschluss und dem ersten Anschluss des ersten Vorspannungstransistors (MN9) und
- einer Spannung zwischen dem Steueranschluss und dem ersten Anschluss des zweiten Transistors (MN8) ; und

- eine zweite Spannung (V21) am vierten Knoten (21) bestimmt ist durch eine Differenz

- einer Spannung zwischen dem Steueranschluss und dem ersten Anschluss des vierten Vorspannungstransistors (MN2) und
- einer Spannung zwischen dem Steueranschluss und dem ersten Anschluss des fünften Transistors (MN3).

14. Verfahren zur Verstärkung,
folgende Schritte umfassend:

- Bereitstellen eines ersten Eingangssignals (VN) an einen ersten Transistor (MP10),
- Bereitstellen eines Stroms (12) an den ersten Transistor (MP10) unter Verwendung eines ersten Vorspannungstransistors (MN9), indem der erste Transistor (MP10) und der erste Vorspannungstransistor (MN9) über einen ersten Knoten (11) in Reihe geschaltet werden,
- Bereitstellen eines Stroms an einen zweiten Transistor (MN8) unter Verwendung eines zweiten Vorspannungstransistors (MN7), indem der zweite Transistor (MN8) und der zweite Vorspannungstransistor (MN7) über einen zweiten Knoten (12) in Reihe geschaltet werden,
- Ausgleichen einer Steuerspannung des ersten Vorspannungstransistors (MN9) und einer Steuerspannung des zweiten Transistors (MN8) und einer Spannung an einem zweiten Anschluss des zweiten Transistors (MN8), und
- Bereitstellen eines ersten verstärkten Signals (VN1), das von der Steuerspannung des ersten Vorspannungstransistors (MN9) abhängt,

dadurch gekennzeichnet, dass
eine erste Spannung (V11) an dem ersten Knoten (11) und eine Spannung an dem zweiten Knoten (12) dadurch ausgeglichen werden, dass der zweite Knoten (12) über eine erste Verbindungsleitung (14), um den zweiten Knoten (12) mit dem ersten Knoten (11) zu koppeln, direkt an den zweiten Knoten (12) angeschlossen wird.

## Revendications

1. Dispositif amplificateur comprenant

- un premier transistor (MP10) présentant une borne de commande à laquelle un premier signal d'entrée (VN) est amené pour amplification,
- un premier transistor de polarisation (MN9) qui est connecté en série au premier transistor (MP10) via un premier noeud (11),
- un deuxième transistor (MN8) présentant une première borne qui est reliée à un deuxième noeud (12), une deuxième borne et une borne de commande ;
la borne de commande du deuxième transistor (MN8) étant reliée à la deuxième borne du deuxième transistor (MN8) et à une borne de commande du premier transistor de polarisation (MN9) via un troisième noeud (13) au niveau duquel un premier signal amplifié (VN1) est fourni, et
- un deuxième transistor de polarisation (MN7), le deuxième transistor (MN8) et le deuxième transistor de polarisation (MN7) étant connectés en série via le deuxième noeud (12),

**caractérisé en ce que**
le deuxième noeud (12) est directement connecté au premier noeud (11) via une première ligne de connexion (14) destinée à relier le deuxième noeud (12) au premier noeud (11) de sorte qu'une première tension (V11) présente au premier noeud (11) et une tension présente au deuxième noeud (12) soient égalisées.

2. Dispositif amplificateur selon la revendication 1,
où le dispositif amplificateur (1) est conçu de telle sorte qu'un courant (14) qui circule dans la première ligne de connexion (14) soit approximativement de 0.

3. Dispositif amplificateur selon la revendication 1 ou 2, comprenant un premier miroir de courant (15), lequel comprend

   - le premier transistor de polarisation (MN9) présentant une première borne qui est connectée à une borne de potentiel de référence (8) et
   - un troisième transistor de polarisation (MN10) présentant une première borne qui est connectée à la borne de potentiel de référence (8) et une borne de commande qui est reliée à la borne de commande du premier transistor de polarisation (MN9).

4. Dispositif amplificateur selon l'une des revendications 1 à 3,
où le dispositif amplificateur (1) est conçu de telle sorte qu'un premier courant (Ic1) qui traverse le deuxième transistor (MN8) soit approximativement égal à un deuxième courant (Ic2) qui traverse le deuxième transistor de polarisation (MN7).

5. Dispositif amplificateur selon l'une des revendications 1 à 4, comprenant

   - un quatrième transistor (MP9) présentant une borne de commande à laquelle un deuxième signal d'entrée (VP) est amené pour amplification,
   - un quatrième transistor de polarisation (MN2) qui est relié au quatrième transistor (MP9) via un quatrième noeud (21),
   - un cinquième transistor (MN3) présentant une première borne qui est reliée à un cinquième noeud (22), une deuxième borne et une borne de commande ;
   la borne de commande du cinquième transistor (MN3) étant reliée à la deuxième borne du cinquième transistor (MN3) et à une borne de commande du quatrième transistor de polarisation (MN2) via un sixième noeud (23) au niveau duquel un deuxième signal amplifié (VP1) est fourni, et
   - un cinquième transistor de polarisation (MN4) qui est relié au cinquième transistor (MN3) via le cinquième noeud (22),

   le cinquième noeud (22) étant relié au quatrième noeud (21) et les premier et quatrième transistors (MP9, MP10) étant reliés l'un à l'autre pour fournir une amplification différentielle des premier et deuxième signaux d'entrée (VN, VP).

6. Dispositif amplificateur selon la revendication 5,
où le cinquième noeud (22) est directement connecté au quatrième noeud (21) via une deuxième ligne de connexion (24) destinée à relier le cinquième noeud (22) au quatrième noeud (21) et où le dispositif amplificateur (1) est conçu de telle sorte qu'un courant (13) qui circule dans la deuxième ligne de connexion (24) est approximativement de 0.

7. Dispositif amplificateur selon la revendication 5 ou 6, dans la mesure où elle dépend de la revendication 4,
où le dispositif amplificateur (1) est conçu de telle sorte qu'un troisième courant (Ic3) qui traverse le cinquième transistor (MN3) et un quatrième courant (Ic4) qui traverse le cinquième transistor de polarisation (MN4) soient approximativement égaux au premier courant (Ic1).

8. Dispositif amplificateur selon l'une des revendications 5 à 7,
comprenant un deuxième miroir de courant (25), lequel comprend

   - le quatrième transistor de polarisation (MN2) présentant une première borne qui est connectée à une borne de potentiel de référence (8) et
   - un sixième transistor de polarisation (MN1) présentant une première borne qui est connectée à la borne de potentiel de référence (8) et une borne de commande qui est reliée à la borne de commande du quatrième transistor de polarisation (MN2).

9. Dispositif amplificateur selon l'une des revendications 5 à 8, comprenant

- un troisième miroir de courant (17) destiné à commander le deuxième transistor de polarisation (MN7) et un quatrième miroir de courant (27) destiné à commander le cinquième transistor de polarisation (MN4) ou
- un cinquième miroir de courant destiné à commander le deuxième transistor de polarisation (MN7) et le cinquième transistor de polarisation (MN4).

10. Dispositif amplificateur selon l'une des revendications 5 à 9, dans la mesure où elle dépend de la revendication 3, comprenant

- un sixième transistor (MP7) présentant une première borne, une deuxième borne qui est reliée à une deuxième borne du sixième transistor de polarisation (MN1), et une borne de commande qui est reliée à la deuxième borne du sixième transistor (MP7),
- un troisième transistor (MP8) présentant une première borne, une deuxième borne qui est reliée à une deuxième borne du troisième transistor de polarisation (MN10) via une borne de sortie d'étage (31), et une borne de commande ;
la borne de commande du troisième transistor (MP8) étant reliée à la borne de commande du sixième transistor (MP7) et
- la borne de sortie d'étage (31) au niveau de laquelle un signal de sortie d'étage (V01) est fourni.

11. Dispositif amplificateur selon la revendication 10, comprenant un étage amplificateur de sortie (32) qui relie la borne de sortie d'étage (31) à une borne de sortie (33) du dispositif amplificateur (1) et comprend

- un premier transistor de sortie (MP12) qui est connecté entre une borne de tension d'alimentation (9) et la borne de sortie (33) et comprend une borne de commande qui est reliée à la borne de sortie d'étage (31),
- un premier transistor de polarisation de sortie (MN12) qui est connecté entre une borne de tension de référence (8) et la borne de sortie (33),
- un condensateur (34) qui est connecté entre la borne de sortie d'étage (31) et la borne de sortie (33) et
- un sixième miroir de courant (35) comprenant le premier transistor de polarisation de sortie (MN12) et un deuxième transistor de polarisation de sortie (MN11).

12. Dispositif amplificateur selon l'une des revendications 5 à 11, comprenant un miroir de courant de base (40), lequel comprend

- un premier transistor miroir (MP1) présentant une deuxième borne sur laquelle un courant de miroir (Ib) est appliqué et une borne de commande qui est reliée à la deuxième borne du premier transistor miroir (MP1),
- un deuxième transistor miroir (MP2) présentant une deuxième borne qui est connectée à la deuxième borne du cinquième transistor (MN3),
- un quatrième transistor miroir (MP4) présentant une deuxième borne qui est connectée à la première borne du premier transistor (MP10) via un noeud (41), et
- un sixième transistor miroir (MP6) présentant une deuxième borne qui est connectée à la deuxième borne du deuxième transistor (MN8),

les premières bornes des premier, deuxième, quatrième et sixième transistors miroirs (MP1, MP2, MP4, MP6) étant connectées à une borne de tension d'alimentation (9) et les bornes de commande des deuxième, quatrième et sixième transistors miroirs (MP2, MP4, MP6) étant connectées à la deuxième borne du premier transistor miroir (MP1).

13. Dispositif amplificateur selon l'une des revendications 5 à 12, où

- une première tension (V11) présente au premier noeud (11) est déterminée par une différence de

- une tension entre la borne de commande et la première borne du premier transistor de polarisation (MN9) et
- une tension entre la borne de commande et la première borne du deuxième transistor (MN8) ; et

- une deuxième tension (V21) présente au quatrième noeud (21) est déterminée par une différence de

- une tension entre la borne de commande et la première borne du quatrième transistor de polarisation (MN2) et

- une tension entre la borne de commande et la première borne du cinquième transistor (MN3).

**14.** Procédé d'amplification,
comprenant les étapes suivantes:

- fournir un premier signal d'entrée (VN) à un premier transistor (MP10),
- fournir un courant (12) au premier transistor (MP10) moyennant un premier transistor de polarisation (MN9) en connectant en série le premier transistor (MP10) et le premier transistor de polarisation (MN9) via un premier noeud (11),
- fournir un courant à un deuxième transistor (MN8) moyennant un deuxième transistor de polarisation (MN7) en connectant en série le deuxième transistor (MN8) et le deuxième transistor de polarisation (MN7) via un deuxième noeud (12),
- égaliser une tension de commande du premier transistor de polarisation (MN9) et une tension de commande du deuxième transistor (MN8) et une tension d'une deuxième borne du deuxième transistor (MN8) et
- fournir un premier signal amplifié (VN1) en fonction de la tension de commande du premier transistor de polarisation (MN9),

**caractérisé en ce que**
une première tension (V11) présente au premier noeud (11) et une tension présente au deuxième noeud (12) sont égalisées en connectant directement le deuxième noeud (12) au premier noeud (11) via une première ligne de connexion (14) destinée à relier le deuxième noeud (12) au premier noeud (11).

Fig. 1

Fig. 2B

Fig. 2A

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20040113696 A1

### Non-patent literature cited in the description

- **C. Leung et al.** A 1-V Integrated Current-Mode Boost Converter in Standard 3.3/5-V CMOS Technologies. *IEEE Journal of Solid-State Circuits,* November 2005, vol. 40 (11), 2265-2274
- **G. A. Rincón-Mora ; H. P. Forghanizadeh.** Accurate and Lossless Current-Sensing Techniques for Power Applications -- A Practical Myth?. *Power Management Design Line,* 16 March 2005

- **D. M. Binkle et al.** Micropower, 0.35-$\mu$m Partially Depleted SOI CMOS Preamplifiers having Low White and Flicker Noise. *IEEE International SOI Conference Proceedings,* 29 September 2003, 85-86